# EUROPÄISCHE PATENTSCHRIFT

(11) **EP 0 759 100 B1**
(45) Veröffentlichungstag und Bekanntmachung des Hinweises auf die Patenterteilung: **11.03.1998**
(21) Anmeldenummer: 95919443.2
(22) Anmeldetag: 11.05.1995
(51) Int. Cl.: C25D 17/00

(54) **VORRICHTUNG ZUR BEHANDLUNG VON LEITERPLATTEN**
DEVICE FOR PROCESSING PRINTED CIRCUIT BOARDS
DISPOSITIF DE TRAITEMENT DE CIRCUITS IMPRIMES

(30) Priorität: 11.05.1994 DE 4416710
(43) Veröffentlichungstag der Anmeldung: 26.02.1997
(73) Patentinhaber: Siemens S.A., 1060 Bruxelles (BE)
(72) Erfinder: HEERMANN, Marcel, 9200 Merelbeke (BE); HOSTEN, Daniel, 8610 Handzame (BE)
(74) Vertreter: Fuchs, Franz-Josef, Dr.-Ing.
(86) Internationale Anmeldenummer: EP9501790
(87) Internationale Veröffentlichungsnummer: WO9531590

(56) Entgegenhaltungen:
- EP-A- 0 421 127
- US-A- 4 372 825
- US-A- 4 401 522

## Beschreibung

Aus der EP-A-0 254 962 ist eine Vorrichtung zum Durchkontaktieren und Galvanisieren von Leiterplatten bekannt, bei welcher die einzelnen Leiterplatten in horizontaler Lage auf einem horizontalen Transportweg kontinuierlich durch nacheinander angeordnete Behandlungsbäder geführt werden. Der Transport der Leiterplatten durch die in Behandlungszellen untergebrachten Behandlungsbäder erfolgt über horizontal angeordnete Transportrollen oder über an endlos umlaufenden Trieben angeordnete Klemmen, welche die seitlichen Ränder der Leiterplatten erfassen. Im Falle einer galvanischen Behandlung übernehmen die Klemmen gleichzeitig auch die kathodische Kontaktierung der Leiterplatten. In den Stirnwänden der Behandlungszellen befinden sich horizontale Schlitze für den Durchtritt der Leiterplatten, wobei diesen horizontalen Schlitzen als Dichtungen horizontal angeordnete und mit einer auf die Geschwindigkeit der durchlaufenden Leiterplatten abgestimmten Drehzahl angetriebene Walzenpaare zugeordnet sind. Die aus den einzelnen Behandlungszellen austretende Badflüssigkeit wird in zugeordneten Auffangwannen aufgefangen und mit Hilfe entsprechender Pumpen kontinuierlich in die zugeordneten Behandlungszellen zurückgeführt. Durch diese kontinuierliche Rückführung der Badflüssigkeit wird in den einzelnen Behandlungszellen die Aufrechterhaltung eines konstanten Pegelstandes ermöglicht.

Aus der EP-A-0 421 127 ist eine Vorrichtung zur Behandlung von Leiterplatten bekannt, bei welcher die einzelnen Leiterplatten in senkrecht hängender Lage auf einem horizontalen Transportweg kontinuierlich durch nacheinander angeordnete Behandlungsbäder geführt werden. Der Transport der Leiterplatten durch die in Behandlungszellen untergebrachten Behandlungsbäder erfolgt über an endlos umlaufenden Trieben angeordnete Klammern, die im Falle einer galvanischen Behandlung gleichzeitig auch die kathodische Kontaktierung der Leiterplatten übernehmen. In den Stirnwänden der Behandlungszellen befinden sich vertikale Schlitze für den Durchtritt der Leiterplatten, wobei im Durchtrittsbereich als Bürstendichtungen oder Streifenbürstendichtungen ausgebildete Dichtungen vorgesehen sind. Die einzelnen Behandlungszellen sind in Auffangwannen angeordnet, aus welchen die aufgefangene Badflüssigkeit mit Hilfe entsprechender Pumpen kontinuierlich in die zugeordneten Behandlungszellen zurückgeführt wird. Auch hier wird durch die kontinuierliche Rückführung der Badflüssigkeit die Aufrechterhaltung eines konstanten Pegelstandes in den einzelnen Behandlungszellen ermöglicht.

Aus der US-A-4 401 522 ist eine ähnlich aufgebaute Vorrichtung zur elektrolytischen Behandlung von Leiterplatten bekannt, bei welcher den vertikalen Schlitzen in den Stirnwänden der Behandlungszellen als Dichtungen vertikal angeordnete Walzenpaare zugeordnet sind. Die aus einem elastischen Material bestehenden Walzen dieser Walzenpaare werden federnd gegeneinander gedrückt und mit einer auf die Transportgeschwindigkeit der durchlaufenden Leiterplatten abgestimmten Drehzahl angetrieben.

Den in den Ansprüchen 1 und 2 angegebenen Erfindungen liegt das Problem zugrunde, eine Vorrichtung zur Behandlung von Leiterplatten in nacheinander angeordneten Behandlungsbädern zu schaffen, bei welcher mit relativ geringem zusätzlichem Aufwand eine deutliche Steigerung des Durchsatzes erzielt werden kann.

Der Erfindung liegt die Erkenntnis zugrunde, daß eine Behandlung der Leiterplatten in vertikaler Lage eine gedrängte, raumsparende Anordnung mit mindestens zwei parallel nebeneinander und auf gleicher Hohe verlaufenden Transportwegen ermöglicht, wobei bereits die Verwendung gemeinsamer Auffangwannen gegenüber getrennt aufgebauten Einzelanlagen zu einer erheblichen Reduzierung des Gesamtaufwands führt. Gemäß Anspruch 1 sind dabei die gemeinsamen Auffangwannen für die aus nebeneinander angeordneten Behandlungszellen austretende Badflüssigkeit vorgesehen, während gemäß Anspruch 2 für die den Transportwegen zugeordneten und nebeneinander angeordneten Behandlungszonen sowohl eine gemeinsame Auffangwanne, als auch eine gemeinsame Behandlungszelle vorgesehen sind. Es wird also eine Verdoppelung bzw. Vervielfachung des Durchsatzes ermöglicht, wobei für die nebeneinander angeordneten Behandlungszonen der parallel verlaufenden Transportwege eine gemeinsamen Auffangwanne, eine gemeinsame Heizung oder Kühlung, eine gemeinsame Niveauüberwachung im Vorratsbehälter, eine gemeinsame Pumpe entsprechender Leistung und die gemeinsame Verwendung weiterer Komponenten erhebliche Einsparungen ermöglichen. Hervorzuheben ist weiterhin, daß auch bei mehreren parallel verlaufenden Transportwegen die Zugänglichkeit der einzelnen Behandlungsbäder, eine effektive Badüberwachung und eine einfache Wartung der gesamten Vorrichtung voll gewährleistet sind.

Im Sinne der vorliegenden Erfindung sind unter dem Begriff "Leiterplatten" nicht nur konventionelle gebohrte Leiterplatten, sondern auch andere plattenförmige Verdrahtungen zu verstehen, die auch zum Aufbau mehrerer Verdrahtungslagen die Vorrichtung gegebenenfalls mehrfach durchlaufen können. Neben dem konventionellen Durchkontaktieren und Galvanisieren von Leiterplatten mit den entsprechenden Vor- und Nachbehandlungsschritten, kann in der erfindungsgemäßen Vorrichtung beispielsweise auch eine Elektrotauchlackierung der Leiterplatten vorgenommen werden. Die durch Elektrotauchlackierung aufgebrachten Schichten können dabei als Galvanoresist, als Ätzresist, als Lötstoplack oder auch als isolierende Zwischenschichten beim Aufbau mehrlagiger Verdrahtungen dienen. Gemäß der vorliegenden Erfindung werden die Leiterplatten in vertikaler Lage durch zumindest annähernd vertikal ausgerichtete Schlitze in den Stirnwänden der Behandlungs - zellen geführt, d.h. es liegt keine Einschränkung auf eine absolut senkrechte Ausrichtung vor. Mit einer leicht geneigten Anordnung von Leiterplatten und Schlitzen, können die Vorteile der Erfindung im Gegensatz zu Vorrichtungen mit der vorherrschenden horizontalen Anordnung ebenfalls realisiert werden.

Vorteilhafte Ausgestaltungen der Erfindung sind in den Ansprüchen 3 bis 19 angegeben.

Die Ausgestaltung nach Anspruch 3 ermöglicht einen besonders einfach zu realisierenden hängenden Transport der Leiterplatten.

Die Weiterbildung nach Anspruch 4 ermöglicht eine einfache und zuverlässige Halterung der Leiterplatten durch Klemmen, wobei derartige Klemmen insbesondere auch für eine automatische Beschickung und Entnahme der Leiterplatten geeignet sind.

Die Ausgestaltung nach Anspruch 5 gewährleistet einen sicheren Transport der Leiterplatten durch die Behandlungszellen in vertikaler Lage.

Die Weiterbildung nach Anspruch 6 ermöglicht durch die gemeinsame Transportvorrichtung für die nebeneinander verlaufenden Transportwege eine weitere erhebliche Reduzierung des Gesamtaufwands. Die Verwendung von Führungsschienen und Führungsrollen gemäß Anspruch 7, gewährleistet auch bei drei oder mehreren Transportwegen eine sichere Führung der Transportmittel.

Die Ausgestaltung nach Anspruch 8 ermöglicht eine weitere Vereinfachung des Transports der Leiterplatten, wobei sich die Verwendung einer endlos umlaufenden Kette gemäß Anspruch 9 als ein besonders zuverlässiges und robustes Antriebsmittel bewährt hat.

Die Ausgestaltung nach Anspruch 10 ermöglicht eine elektrolytische Behandlung der Leiterplatten, wobei die Anordnung der Elektroden zu beiden Seiten der Transportwege gemäß Anspruch 11 eine hohe Gleichmäßigkeit und Effektivität dieser elektrolytischen Behandlung gewährleistet.

Gemäß Anspruch 12 kann bei einer elektrolytischen Behandlung die elektrische Kontaktierung der Leiterplatten auf besonders einfache und sichere Weise über die Transportmittel vorgenommen werden.

Die Ausgestaltung nach Anspruch 13 ermöglicht eine einfache Beseitigung von Metallabscheidungen auf den Transportmitteln durch chemisches oder anodisches Ätzen.

Die Ausgestaltung nach Anspruch 14 ermöglicht eine besonders effektive Behandlung der Leiterplatten durch die kontinuierliche und gezielte Zuführung von Badflüssigkeit zu den Leiterplatten. Dabei hat sich eine vertikale Ausrichtung der Sprührohre gemäß Anspruch 15 besonders bewährt, während eine Anordnung der Sprührohre zu beiden Seiten der Transportwege gemäß Anspruch 16 eine gleiche und gleichmäßige Behandlung beider Leiterplattenseiten gewährleistet.

Die Weiterbildung nach Anspruch 17 ermöglicht durch die Bildung von Mikroturbulenzen eine weitere Erhöhung der Intensität der Behandlung. So ermöglicht beispielsweise die Einleitung von Druckluft in eine galvanische Behandlungszelle höhere Stromdichten und damit eine Verkürzung der Gesamtlänge der Vorrichtung.

Die Ausgestaltung nach Anspruch 18 ermöglicht eine besonders einfache und wirkungsvolle Abdichtung der für den Durchlauf der Leiterplatten erforderlichen Schlitze. Gemäß Anspruch 19 kann dabei die lose und vertikale Ausrichtung der als Dichtung verwendeten Zylinder auf einfache Weise durch deren Unterbringung in Schleusenkammern gewährleistet werden.

Ausführungsbeispiele der Erfindung sind in der Zeichnung dargestellt und werden im Folgenden näher beschrieben.

Es zeigen
- Figur 1 und Figur 2: eine erste Ausführungsform einer Vorrichtung zur mehrspurigen Behandlung von Leiterplatten in der Draufsicht bzw. im Querschnitt,
- Figur 3 und Figur 4: eine zweite Ausführungsform einer Vorrichtung zur mehrspurigen Behandlung von Leiterplatten in der Draufsicht bzw. im Querschnitt,
- Figur 5: einen Querschnitt durch ein galvanisches Behandlungsmodul mit zwei nebeneinander angeordneten Behandlungszellen,
- Figur 6: die beiden Behandlungszellen des in Figur 5 dargestellten Behandlungsmoduls in der stirnseitigen Draufsicht bzw. im Querschnitt,
- Figur 7: einen Querschnitt der Transportvorrichtung des in Figur 5 dargestellten Behandlungsmoduls und
- Figur 8: eine Draufsicht auf die Transportvorrichtung gemäß Anspruch 7.

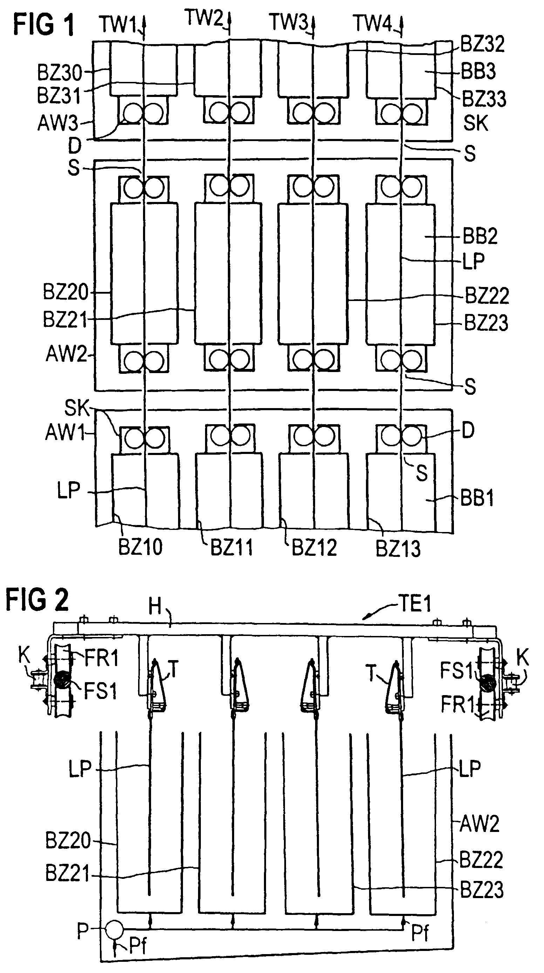

Die Figuren 1 und 2 zeigen in stark vereinfachter schematischer Darstellung ein erstes Ausführungsbeispiel einer Vorrichtung zur Behandlung von Leiterplatten LP, die mit Hilfe von Transportmitteln T in vertikal hängender Lage auf vier parallel nebeneinander und auf gleicher Höhe verlaufenden horizontalen Transportwegen TW1, TW2, TW3 und TW4 durch nacheinander angeordnete Behandlungsbäder geführt werden. In dem in Figur 1 dargestellten Ausschnitt der Vorrichtung sind diese nacheinander angeordneten Behandlungsbäder mit BB1, BB2 und BB3 bezeichnet.

Zur Aufnahme des Behandlungsbades BB1 sind vier nebeneinander angeordnete und den Transportwegen TW1 bis TW4 zugeordnete Behandlungszellen BZ10, BZ11, BZ12 und BZ13 vorgesehen, die in einer gemeinsamen Auffangwanne AW1 aufgestellt sind.

Zur Aufnahme des Behandlungsbades BB2 sind vier nebeneinander angeordnete und den Transportwegen TW1 bis TW4 zugeordnete Behandlungszellen BZ20, BZ21, BZ22 und BZ23 vorgesehen, die in einer gemeinsamen Auffangwanne AW2 aufgestellt sind.

Zur Aufnahme des Behandlungsbades BB3 sind vier nebeneinander angeordnete und den Transportwegen TW1 bis TW4 zugeordnete Behandlungszellen BZ30, BZ31, BZ32 und BZ33 vorgesehen, die in einer gemeinsamen Auffangwanne AW3 aufgestellt sind.

Die Stirnwände sämtlicher Behandlungszellen sind mit vertikalen Schlitzen S versehen, die so bemessen sind, daß die Leiterplatten LP entlang der Transportwege TW1 bis TW4 ungehindert hindurchgeführt werden können. Stirnseitig an den Behandlungszellen angebrachte Schleusenkammern SK nehmen mit D bezeichnete Dichtungen auf, die den Austritt von Badflüssigkeit aus den vertikalen Schlitzen S stark verringern. Bei den Dichtungen D handelt es sich um paarweise, in vertikaler Ausrichtung lose angeordnete Zylinder , die durch den Druck der Badflüssigkeit gegeneinander oder gegen die jeweils durchlaufende Leiterplatte LP gedrückt werden. Die Stirnwände der Schleusenkammern SK und der gemeinsamen Auffangwannen AW1 bis AW3 sind für den Durchtritt der Leiterplatten LP ebenso wie die Stirnwände der Behandlungszellen mit vertikalen Schlitzen S versehen.

Die aus den einzelnen Behandlungszellen im Bereich der Schlitze S austretende oder aus den Behandlungszellen überlaufende Badflüssigkeit wird in den zugeordneten gemeinsamen Auffangwannen AW1, AW2 oder AW3 aufgefangen. Aus dem in Figur 2 dargestellten Querschnitt durch die vier nebeneinander angeordneten Behandlungszellen BZ20 bis BZ23 und deren gemeinsame Auffangwanne AW2, ist ersichtlich, daß die aufgefangene Badflüssigkeit mit Hilfe einer gemeinsamen Pumpe P kontinuierlich in die zugeordneten Behandlungszellen BZ20 bis BZ23 zurückgeführt wird, wobei diese Rückführung durch Pfeile Pf angedeutet ist. Auf diese Weise kann in den Behandlungszellen BZ20 bis BZ23 ein konstanter Pegelstand der Badflüssigkeit aufrechterhalten werden.

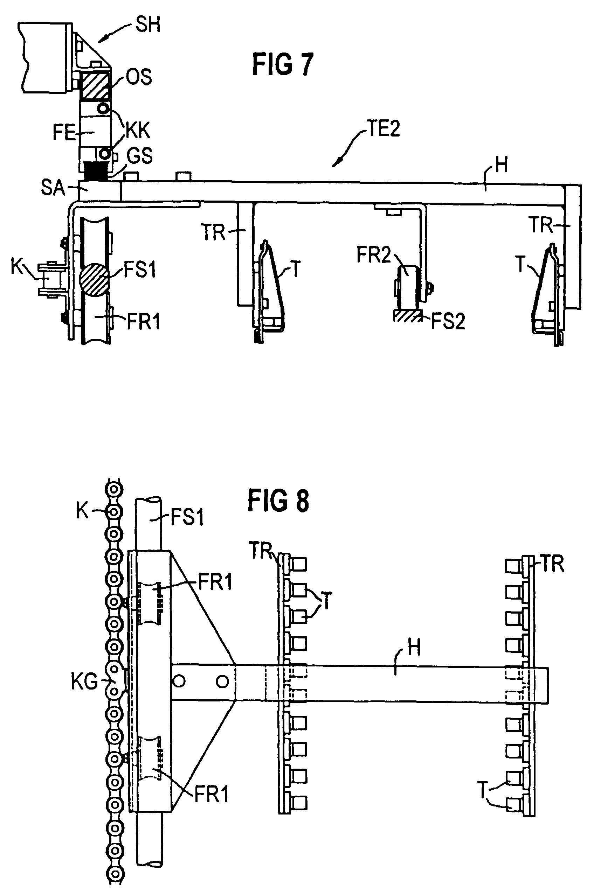

Aus dem in Figur 2 dargestellten Querschnitt ist ferner ersichtlich, daß die vier als Klemmen ausgebildeten Transportmittel T Teil einer gemeinsamen Transportvorrichtung TE1 sind. Die Transportmittel T sind dabei im Abstand der zugeordneten Transportwege TW1 bis TW4 (vergleiche Figur 1) an gemeinsamen Haltern H befestigt, welche ihrerseits über Führungsrollen FR1 auf zu beiden Seiten verlaufenden runden Führungsschienen FS1 geführt sind. Der Antrieb der gesamten Transportvorrichtung TE1 erfolgt über beidseitig an die Halter H angekoppelte und jeweils endlos umlaufende Ketten K. Die gemeinsamen Transportvorrichtung TE1 bietet auch die Möglichkeit einer anodischen oder kathodischen Kontaktierung der Leiterplatten LP oberhalb elektrolytischer Behandlungszellen. Auf diese Möglichkeit der Kontaktierung wird jedoch erst an späterer Stelle im Zusammenhang mit der in den Figuren 7 und 8 dargestellten Transportvorrichtung TE2 näher eingegangen.

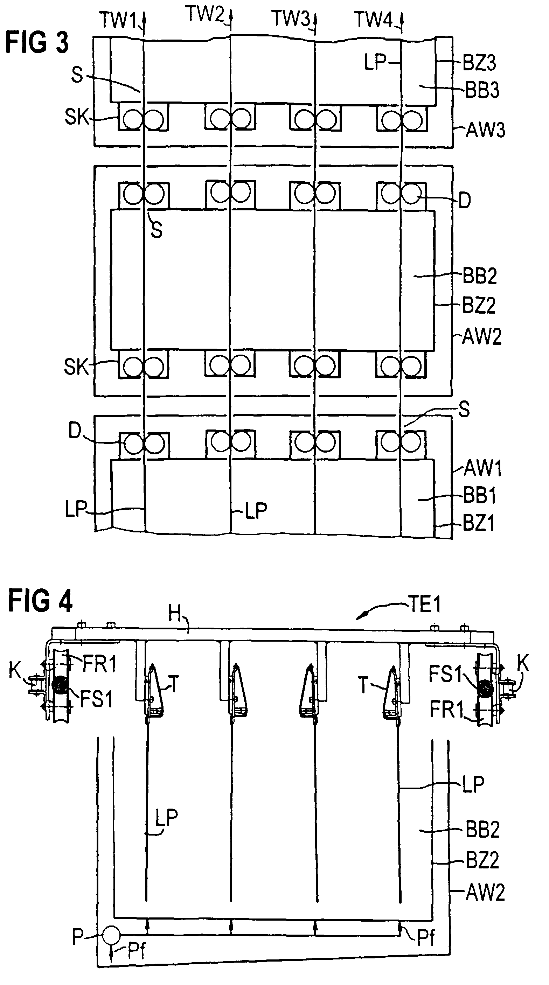

Die Figuren 3 und 4 zeigen in stark vereinfachter schematischer Darstellung ein zweites Ausführungsbeispiel einer Vorrichtung zur Behandlung von Leiterplatten LP, die wie beim ersten Ausführungsbeispiel wieder mit Hilfe von Transportmitteln T in vertikal hängender Lage auf vier parallel nebeneinander und auf gleicher Höhe verlaufenden Transportwegen TW1, TW2, TW3 und TW4 durch nacheinander angeordnete Behandlungsbäder geführt werden. Im Hinblick auf den weitgehend gleichen Aufbau der in den Figuren 1 und 2 bzw. in den Figuren 3 und 4 dargestellten Ausführungsbeispiele und auf die Verwendung gleicher Bezugszeichen für gleiche Teile und Bäder, wird im folgenden vor allem auf die Unterschiede zwischen den beiden Ausführungsbeispielen eingegangen.

Bei dem in den Figuren 3 und 4 dargestellten zweiten Ausführungsbeispiel sind anstelle von vier nebeneinander angeordneten einzelnen Behandlungszellen für die Unterbringung der Behandlungsbäder BB1 bis BB3 jeweils gemeinsame Behandlungszellen vorgesehen, die bei dem in Figur 3 dargestellten Ausschnitt der gesamten Vorrichtung mit BZ1, BZ2 und BZ3 bezeichnet sind.

Die Unterbringung des Behandlungsbades BB1 erfolgt also in der gemeinsamen Behandlungszelle BZ1, durch welche die vier Transportwege TW1 bis TW4 führen. An den Durchtrittsstellen für die Leiterplatten LP sind auch hier wieder vertikale Schlitze S und Schleusenkammern SK mit Dichtungen D vorgesehen. Die Aufstellung der gemeinsamen Behandlungszelle erfolgt wieder in der gemeinsamen Auffangwanne AW1.

In entsprechender Weise sind die nachfolgenden Behandlungsbäder BB2 und BB3 in den gemeinsamen Behandlungszellen BZ2 und BZ3 untergebracht, wobei diese gemeinsamen Behandlungszellen BZ2 und BZ3 in den zugeordneten gemeinsamen Auffangwannen AW2 bzw. AW3 aufgestellt sind.

Die Rückführung der beispielsweise in der gemeinsamen Behandlungswanne AW2 aufgefangenen Badflüssigkeit in die gemeinsame Behandlungszelle BZ2, erfolgt gemäß dem in Figur 4 dargestellten Querschnitt an vier Stellen. Eine gemeinsame Rückführung der Badflüssigkeit oder andere Arten der Rückführung und Verteilung der Badflüssigkeit, sind jedoch ebenfalls möglich.

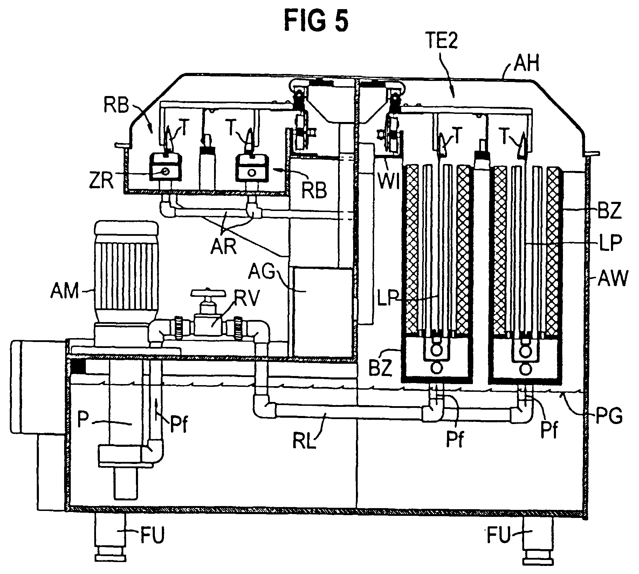

Figur 5 zeigt einen Querschnitt durch ein galvanisches Behandlungsmodul mit zwei nebeneinander angeordneten galvanischen Behandlungszellen BZ, die in einer gemeinsamen Auffangwanne AW angeordnet sind. Die auf Füßen FU aufgestellte und oben mit einer abnehmbaren Abdeckhaube AH geschlossene Auffangwanne AW enthält einen Vorrat des galvanischen Behandlungsbades, dessen Pegelstand mit PG bezeichnet ist. Neben dieser Funktion als Vorratsbehälter hat die gemeinsame Auffangwanne AW auch noch die Aufgabe, die aus den beiden Behandlungszellen BZ austretende Badflüssigkeit aufzunehmen. Zur Konstanthaltung des Pegelstandes in den beiden Behandlungszellen BZ ist eine als Tauchpumpe ausgebildete Pumpe P innerhalb der Auffangwanne AW angeordnet, so daß über eine Rücklaufleitung RL die Badflüssigkeit in Richtung der Pfeile Pf kontinuierlich in die Behandlungszellen BZ zurückgeführt werden kann. Zur Einstellung der Rücklaufmenge befindet sich außerhalb der Auffangwanne AW neben dem Antriebsmotor AM der Pumpe P ein in die Rücklaufleitung RL eingefügtes Regelventil RV.

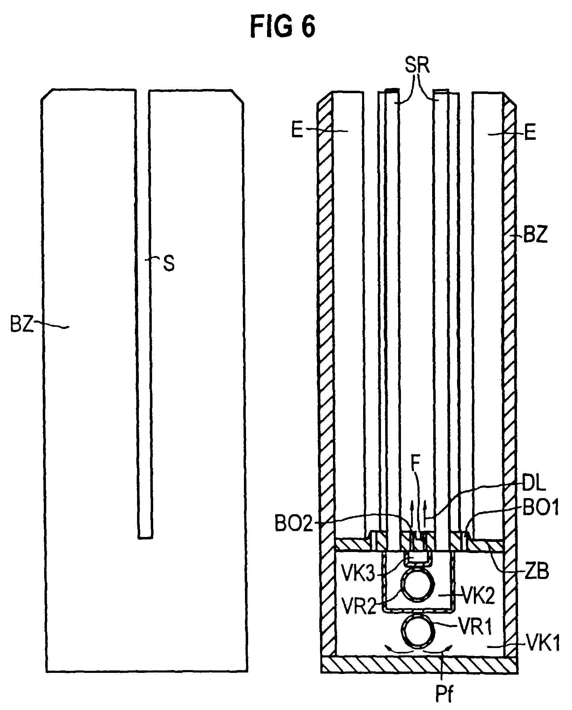

Zur weiteren Erläuterung der beiden in der Auffangwanne AW angeordneten galvanischen Behandlungszellen BZ wird zusätzlich auf die Figur 6 verwiesen. Bei der in Figur 6 links dargestellten Behandlungszelle BZ ist ersichtlich, daß deren Stirnseiten Schlitze S für den Durchtritt der Leiterplatten LP besitzen. Nähere Einzelheiten dieser Schlitze S und der zugeordneten Schleusenkammern SK und Dichtungen D wurden bereits im Zusammenhang mit Figur 1 erörtert. Im unteren Bereich der Behandlungszellen BZ wird durch einen Zwischenboden ZB eine erste Verteilkammer VK1 gebildet, in welche über ein erstes Verteilrohr VR1 ein Teil der von der Pumpe P zurückgeförderten Badflüssigkeit eingeleitet wird. Dieses erste Verteilrohr VR1 ist auf seiner Unterseite mit im Abstand zueinander angeordneten Löchern versehen, aus welchen die Badflüssigkeit austritt, so wie es in Figur 6 durch die Pfeile Pf angedeutet ist. In ähnlicher Weise befinden sich im Zwischenboden ZB zwei Reihen im Abstand zueinander angeordneter Bohrungen BO1, durch welche die Badflüssigkeit aus der ersten Verteilkammer VK1 senkrecht nach oben in den eigentlichen Galvanisierbereich geführt wird.

Innerhalb der ersten Verteilkammer VK1 ist eine am Zwischenboden ZB hängende zweite Verteilkammer VK2 angeordnet, in welche über ein zweites Verteilrohr VR2 der andere Teil der von der Pumpe P zurückgeförderten Badflüssigkeit eingeleitet wird. Aus dieser zweiten Verteilkammer VK2 gelangt die Badflüssigkeit dann in Sprührohre SR, die zu beiden Seiten des Transportweges der Leiterplatten LP senkrecht stehend im Zwischenboden ZB befestigt sind. Die in zwei Reihen angeordneten Sprührohre SR besitzen an ihren Innenseiten eine Vielzahl von in der Zeichnung nicht näher dargestellten Sprühdüsen, über welche die durchlaufenden Leiterplatten LP direkt mit frischer Badflüssigkeit beaufschlagt werden.

Innerhalb der zweiten Verteilkammer VK2 ist eine am Zwischenboden ZB hängende dritte Verteilkammer VK3 angeordnet, in welche Druckluft eingeleitet wird. Die durch Pfeile DL angedeutete Druckluft gelangt dann über zwei Reihen in den Zwischenboden ZB eingebrachter Bohrungen B02 in den Galvanisierbereich. Zwischen den beiden Reihen dieser Bohrungen B02 befindet sich eine Führung F für die Leiterplatten LP, die als U-förmige Nut in den Zwischenboden ZB eingebracht ist.

Innerhalb der galvanischen Behandlungszellen BZ befinden sich oberhalb des Zwischenbodens ZB zu beiden Seiten des Transportweges angeordnete Elektroden E, die sich entlang der Seitenwände in Transportrichtung erstrecken. Bei dem dargestellten galvanischen Behandlungsmodul handelt es sich bei diesen Elektroden um Anoden, die im Falle einer galvanischen Kupferabscheidung beispielsweise aus Titankörben und darin untergebrachten Kupferkugeln bestehen.

Aus dem in Figur 6 dargestellten Querschnitt ist auch noch ersichtlich, daß die beiden Seitenwände der Behandlungszellen BZ mit nicht näher bezeichneten Abschrägungen versehen sind. Hierdurch bilden die Oberkanten der Seitenwände ein definiertes Überfallwehr, über welches die in die Behandlungszellen BZ zurückgeförderte Badflüssigkeit ständig überfließt.

Der Transport der Leiterplatten LP auf zwei im Abstand zueinander senkrecht zur Zeichnungsebene verlaufenden Transportwegen, erfolgt über eine gemeinsame Transportvorrichtung TE2, zu deren weiteren Erläuterung zusätzlich auf die Figuren 7 und 8 verwiesen wird. Zwei wiederum als Klemmen ausgebildete Transportmittel T sind im Abstand der durch die beiden Behandlungszellen BZ führenden Transportwege an Trägern TR befestigt, welche ihrerseits an gemeinsamen, sich quer zur Transportrichtung erstreckenden Haltern H angebracht sind. Zur Führung der einzelnen, jeweils aus einem Halter H, zwei Trägern TR und jeweils zehn an diesen Trägern TR angeordneten Transportmitteln T gebildeten Transportwagen, sind Führungsschienen FS1 und FS2, sowie Führungsrollen FR1 und FR2 vorgesehen. Die auf der Innenseite der gesamten Vorrichtung sich erstreckende runde Führungsschiene FS1, ist im Bereich des dargestellten galvanischen Behandlungsmoduls über Winkel WI an der Auffangwanne AW befestigt, während die im Querschnitt rechteckförmige zweite Führungsschiene FS2 im Bereich zwischen den beiden Behandlungszellen BZ verläuft. Auf der inneren Führungsschiene FS1 ist ein Transportwagen mit jeweils zwei oberen und zwei unteren Führungsrollen FR1 geführt, während zur Abstützung auf der mittleren Führungsschiene FS2 nur eine einzige Führungsrolle FR2 vorgesehen ist. Zum Antrieb der einzelnen Transportwagen dient eine endlos umlaufende Kette K, die sich auf der Innenseite parallel zur Führungsschiene FS1 erstreckt und an deren Koppelglieder KG die einzelnen Halter H angekoppelt sind.

Im Bereich des dargestellten galvanischen Behandlungsmoduls übernimmt die Transporteinrichtung TE2 auch die kathodische Kontaktierung der Leiterplatten LP. Hierzu ist der innenliegende Teil der Halter H als Stromaufnahmeteil SA ausgebildet, das beispielsweise aus Kupfer besteht und den aufgenommenen Strom über den Halter H, die Träger TR und die Transportmittel T zu den daran hängenden Leiterplatten LP führt. Zur Verbesserung der Stromleitung besteht der Halter H aus einem mit Edelstahl ummantelten Kupferstab. Die Stromzufuhr erfolgt über eine obere Stromschiene OS, die aus einem mit Titan ummantelten Kupferstab besteht und über eine Schienenhalterung SH an der Auffangwanne AW befestigt ist. Unterhalb der oberen Stromschiene OS verläuft eine Gleitschiene GS , die beispielsweise aus Graphit besteht und über Federelemente FE federnd gegen die auf ihr schleifenden Stromaufnahmeteile SA gedrückt wird. Zur elektrischen Überbrückung der Federelemente FE sind Kupferkabel KK vorgesehen.

In den galvanischen Behandlungszellen BZ erfolgt neben der erwünschten Metallabscheidung auf den durchlaufenden Leiterplatten LP auch eine unerwünschte Metallabscheidung auf den als Klemmen ausgebildeten Transportmitteln T. Zur Beseitigung dieser unerwünschten Metallabscheidungen sind im Bereich des rücklaufenden Trums der Transportvorrichtung TE2 unterhalb der Abdeckhaube AH zwei Reinigungsbäder RB angeordnet, durch welche der untere Bereich der Transportmittel T geführt wird. Die Entmetallisierung erfolgt durch anodisches Ätzen, d.h. die Transportmittel T werden in diesem rücklaufenden Bereich anodisch kontaktiert. Die Stromzufuhr erfolgt sonst in gleicher Weise, wie die bereits erläuterte kathodische Stromzufuhr im Bereich der Behandlungszellen BZ. Auch der Aufbau der ebenfalls mit Durchlaufschlitzen versehenen Reinigungsbäder RB hat gewisse Ähnlichkeiten mit dem Aufbau der Behandlungszellen BZ. Der Zulauf der Badflüssigkeit erfolgt hier über Zulauf rohre ZR, während für den Ablauf und die Rückführung in die Auffangwanne AW Ablaufrohre AR vorgesehen sind. Die für den Zulauf der Badflüssigkeit erforderliche Pumpe ist in Figur 5 nicht dargestellt.

Unterhalb der vorstehend beschriebenen Reinigungsbäder RB befindet sich noch eine mit AG bezeichnete Absaugung, die zur Erzeugung eines Unterdrucks innerhalb der Auffangwanne AW an eine nicht näher dargestellte zentrale Absaugeinrichtung angeschlossen ist.

## Patentansprüche

1. Vorrichtung zur Behandlung von Leiterplatten (LP), mit Transportmitteln (T), welche die Leiterplatten in zumindest annähernd vertikaler Lage auf mindestens zwei nebeneinander verlaufenden, horizontalen Transportwegen (TW1 bis TW4) kontinuierlich durch nacheinander angeordnete Behandlungsbäder (BB1 bis BB3) führen,
- nacheinander und nebeneinander angeordneten Behandlungszellen (BZ10 bis BZ13;BZ20 bis BZ23,BZ30 bis BZ33;BZ) zur Aufnahme der Behandlungsbäder,
- zumindest annähernd vertikal ausgerichteten Schlitzen (S) in den Stirnwänden der Behandlungszellen für den Durchtritt der Leiterplatten,
- den Schlitzen zugeordneten Dichtungen (D),
- gemeinsamen Auffangwannen (AW1 bis AW3;AW) für die aus nebeneinander angeordneten Behandlungszellen austretende Badflüssigkeit,
und mit
- Pumpen zur kontinuierlichen Rückführung von Badflüssigkeit aus den Auffangwannen in die zugeordneten Behandlungszellen.

2. Vorrichtung zur Behandlung von Leiterplatten (LP), mit
- Transportmitteln (T), welche die Leiterplatten in zumindest annähernd vertikaler Lage auf mindestens zwei nebeneinander verlaufenden, horizontalen Transportwegen (TW1 bis TW4) kontinuierlich durch nacheinander angeordnete Behandlungsbäder (BB1 bis BB3) führen,
- nacheinander angeordneten Behandlungszellen (BZ1 bis BZ3) zur Aufnahme der Behandlungsbäder,
- zumindest annähernd vertikal ausgerichten Schlitzen (S) in den Stirnwänden der Behandlungszellen für den Durchtritt der Leiterplatten,
- den Schlitzen zugeordneten Dichtungen (D),
- Auffangwannen (AW1 bis AW3) für die aus den Behandlungszellen austretende Badflüssigkeit, und mit
- Pumpen (P) zur kontinuierlichen Rückführung von Badflüssigkeit aus den Auffangwannen in die zugeordneten Behandlungszellen.

3. Vorrichtung nach Anspruch 1 oder 2,
gekennzeichnet durch Transportmittel (T) zum hängenden Transport der Leiterplatten.

4. Vorrichtung nach einem der vorhergehenden Ansprüche,
**dadurch gekennzeichnet**,
daß die Transportmittel (T) als Klemmen ausgebildet sind.

5. Vorrichtung nach Anspruch 3 oder 4,
**dadurch gekennzeichnet**,
daß in den Behandlungszellen (BZ) Führungen (F) für die Leiterplatten angeordnet sind.

6. Vorrichtung nach einem der vorhergehenden Ansprüche,
**dadurch gekennzeichnet**,
daß die Transportmittel (T) der nebeneinander verlaufenden Transportwege zu einer gemeinsamen Transportvorrichtung (TE1;TE2) zusammengefaßt sind.

7. Vorrichtung nach Anspruch 6,
**dadurch gekennzeichnet**,
daß die gemeinsame Transportvorrichtung mit auf Führungsschienen (FS1,FS2) laufenden Führungsrollen (FR1,FR2) ausgerüstet ist.

8. Vorrichtung nach Anspruch 6 oder 7,
**dadurch gekennzeichnet**,
daß die Transportmittel der gemeinsamen Transporteinrichtung durch mindestens einen endlos umlaufenden Trieb angetrieben sind.

9. Vorrichtung nach Anspruch 8,
**dadurch gekennzeichnet**,
daß der endlos umlaufende Trieb durch eine Kette (K) gebildet ist.

10. Vorrichtung nach einem der vorhergehenden Ansprüche,
gekennzeichnet durch Kontaktierorgane zur anodischen oder kathodischen Kontaktierung der Leiterplatten und durch in elektrolytischen Behandlungszellen (BZ) angeordnete Elektroden (E) mit der entgegengesetzten Polarität der Kontaktierorgane.

11. Vorrichtung nach Anspruch 10,
**dadurch gekennzeichnet**,
daß die Elektroden zu beiden Seiten der Transportwege der Leiterplatten angeordnet sind.

12. Vorrichtung nach Anspruch 10 oder 11,
**dadurch gekennzeichnet**,
daß die Kontaktierorgane durch die Transportmittel (T) gebildet sind und daß die Stromzuführung zu den Transportmitteln mittels Schleifkontaktierung oder Rollenkontaktierung erfolgt.

13. Vorrichtung nach den Ansprüchen 8 und 12,
**dadurch gekennzeichnet**,
daß im Bereich des rücklaufenden Trums des endlosen Triebes mindestens ein Reinigungsbad (RB) zur chemischen oder elektrochemischen Reinigung der Transportmittel angeordnet ist.

14. Vorrichtung nach einem der vorhergehenden Ansprüche,
**dadurch gekennzeichnet**,
daß die Rückführung der Badflüssigkeit zumindest teilweise über in der zugehörigen Behandlungszelle (BZ) angeordnete Sprührohre (SR) erfolgt.

15. Vorrichtung nach Anspruch 14,
gekennzeichnet durch vertikal ausgerichtete Sprührohre.

16. Vorrichtung nach Anspruch 14 oder 15,
**dadurch gekennzeichnet**,
daß die Sprührohre zu beiden Seiten der Transportwege der Leiterplatten angeordnet sind.

17. Vorrichtung nach einem der vorhergehenden Ansprüche,
gekennzeichnet durch Mittel zur Einleitung von Druckluft (DL) in die Behandlungsbäder.

18. Vorrichtung nach einem der vorhergehenden Ansprüche,
**dadurch gekennzeichnet**,
daß die Dichtungen (D) durch paarweise, in vertikaler Ausrichtung lose angeordnete Zylinder gebildet sind, die durch den Druck eines Behandlungsbades (BB1 bis BB3) gegeneinander oder gegen die jeweils durchlaufenden Leiterplatten (LP) gedrückt werden.

19. Vorrichtung nach Anspruch 18,
**dadurch gekennzeichnet**,
daß die Dichtungen (D) in stirnseitig an den Behandlungszellen angebrachten Schleusenkammern (SK) angeordnet sind.

## Claims

1. Apparatus for the treatment of printed circuit boards (LP), having transport means (T) which continuously carry the printed circuit boards in an at least approximately vertical position through treatment baths (BB1 to BB3), which are arranged one after the other, on at least two horizontal transport paths (TW1 to TW4) running side by side,
- treatment cells (BZ10 to BZ13;BZ20 to BZ23,BZ30 to BZ33;BZ), which are arranged one after the other and side by side, for accommodating the treatment baths,
- at least approximately vertically aligned slits (S) in the end walls of the treatment cells for the printed circuit boards to pass through,
- seals (D) assigned to the slits,
- common catchment troughs (AW1 to AW3;AW) for the bath liquid emerging from treatment cells which are arranged side by side,
and having
- pumps for continuously returning bath liquid from the catchment troughs to the associated treatment cells.

2. Apparatus for the treatment of printed circuit boards (LP), having
- transport means (T) which continuously carry the printed circuit boards in an at least approximately vertical position through treatment baths (BB1 to BB3), which are arranged one after the other, on at least two horizontal transport paths (TW1 to TW4) running side by side,
- treatment cells (BZ1 to BZ3), which are arranged one after the other, for accommodating the treatment baths,
- at least approximately vertically aligned slits (S) in the end walls of the treatment cells for the printed circuit boards to pass through,
- seals (D) assigned to the slits,
- catchment troughs (AW1 to AW3) for the bath liquid emerging from the treatment cells,
and having
- pumps (P) for continuously returning bath liquid from the catchment troughs to the associated treatment cells.

3. Apparatus according to Claim 1 or 2, characterized by transport means (T) for the suspended transport of printed circuit boards.

4. Apparatus according to one of the preceding claims, characterized in that the transport means (T) are designed as clamps.

5. Apparatus according to Claim 3 or 4, characterized in that guides (F) for the printed circuit boards are arranged in the treatment cells (BZ).

6. Apparatus according to one of the preceding claims, characterized in that the transport means (T) of the transport paths running side by side are combined to form a common transport apparatus (TE1;TE2).

7. Apparatus according to Claim 6, characterized in that the common transport apparatus is equipped with guide rollers (FR1,FR2) which run on guide tracks (FS1,FS2).

8. Apparatus according to Claim 6 or 7, characterized in that the transport means of the common transport device are driven by at least one endlessly running drive.

9. Apparatus according to Claim 8, characterized in that the endlessly running drive is formed by a chain (K).

10. Apparatus according to one of the preceding claims, characterized by contact-making devices for making anodic or cathodic contact with the printed circuit boards, and by electrodes (E) which are arranged in electrolytic treatment cells (BZ) and whose polarity is opposite that of the contact-making devices.

11. Apparatus according to Claim 10, characterized in that the electrodes are arranged on both sides of the transport paths of the printed circuit boards.

12. Apparatus according to Claim 10 or 11, characterized in that the contact-making devices are formed by the transport means (T), and in that electrical power is supplied to the transport means by sliding contacts or roller contacts.

13. Apparatus according to Claims 8 and 12, characterized in that at least one cleaning bath (RB) for chemical or electrochemical cleaning of the transport means is arranged in the region of the returning side of the endless drive.

14. Apparatus according to one of the preceding claims, characterized in that the bath liquid is at least partially returned via spray tubes (SR) which are arranged in the associated treatment cell (BZ).

15. Apparatus according to Claim 14, characterized by vertically aligned spray tubes.

16. Apparatus according to Claim 14 or 15, characterized in that the spray tubes are arranged on both sides of the transport paths of the printed circuit boards.

17. Apparatus according to one of the preceding claims, characterized by means for introducing compressed air (DL) into the treatment baths.

18. Apparatus according to one of the preceding claims, characterized in that the seals (D) are formed by cylinders which are arranged in pairs with a loose vertical alignment and are pressed, by the pressure of a treatment bath (BB1 to BB3), against one another or against the respective printed circuit boards (LP) passing through.

19. Apparatus according to Claim 18, characterized in that the seals (D) are arranged in sluice chambers (SK) which are fitted at the ends to the treatment cells.

## Revendications

1. Dispositif de traitement de circuits imprimés (LP), comprenant
- des moyens de transport (T) qui transportent les circuits imprimés, en position au moins à peu près verticale, sur aux moins deux chemins de transport horizontaux (TW1 à TW4) suivant des trajectoires proches l'une de l'autre, et les font passer en continu dans des bains de traitement disposés les uns derrière les autres (BB1 à BB3),
- des cellules de traitement (BZ10 à BZ13; BZ20 à BZ23, BZ30 à BZ33; BZ) disposées les unes derrière les autres et les unes à côté des autres servant à recevoir les bains de traitement,
- des fentes (S) orientées de manière au moins à peu près verticale dans les parois frontales des cellules de traitement pour le passage des circuits imprimés,
- des dispositifs d'étanchéité (D) associés aux fentes,
- des cuves de récupération communes (AW1 à AW3; AW) pour le liquide de bain sortant de cellules de traitement disposées les unes à côté des autres,
et comprenant
- des pompes pour la remise en circulation continuelle du liquide de bain des cuves de récupération dans les cellules de traitement associées.

2. Dispositif de traitement de circuits imprimés (LP), comprenant
- des moyens de transport (T) qui transportent les circuits imprimés, en position au moins à peu près verticale, sur au moins deux chemins de transports horizontaux (TW1 à TW4) suivant des trajectoires proches l'une de l'autre, et les font passer en continu dans des bains de traitement disposés les uns derrière les autres (BB1 à BB3),
- des cellules de traitement disposées les unes.derrière les autres (BZ1 à BZ3) servant à recevoir les bains de traitement,
- des fentes (S) orientées de manière au moins à peu près verticale dans les parois frontales des cellules de traitement pour le passage des circuits imprimés,
- des dispositifs d'étanchéité (D) associés aux fentes,
- des cuves de récupération (AW1 à AW3) pour le liquide de bain sortant des cellules de traitement,
et comprenant
- des pompes (P) pour la remise en circulation continuelle du liquide de bain des cuves de récupération dans les cellules de traitement associées.

3. Dispositif selon la revendication 1 ou 2, caractérisé par des moyens de transport (T) pour le transport suspendu des circuits imprimés.

4. Dispositif selon l'une des revendications précédentes, caractérisé en ce que les moyens de transport (T) sont exécutés en tant que pinces.

5. Dispositif selon la revendication 3 ou 4, caractérisé en ce que des guides (F) pour les circuits imprimés sont situés dans les cellules de traitement (BZ).

6. Dispositif selon l'une des revendications précédentes, caractérisé en ce que les moyens de transport (T) des chemins de transport suivant des trajectoires proches l'une de l'autre sont assemblés de manière à former un dispositif de transport commun (TE1;TE2).

7. Dispositif selon la revendication 6, caractérisé en ce que le dispositif de transport commun est équipé de galets de guidage (FR1, FR2) roulant sur des rails de guidage (FS1, FS2).

8. Dispositif selon la revendication 6 ou 7, caractérisé en ce que les moyens de transport du dispositif de transport commun sont entraînés par au moins un dispositif de commande à rotation continue.

9. Dispositif selon la revendication 8, caractérisé en ce que le dispositif de commande à rotation continue est formé par une chaîne (K).

10. Dispositif selon l'une des revendications précédentes, caractérisé par des éléments de contact pour la mise en contact anodique ou cathodique des circuits imprimés, et par des électrodes (E) avec une polarité opposée aux éléments de contact situées dans les cellules de traitement électrolytique (BZ).

11. Dispositif selon la revendication 10, caractérisé en ce que les électrodes sont situées sur les deux côtés des chemins de transport des circuits imprimés.

12. Dispositif selon la revendication 10 ou 11, caractérisé en ce que les éléments de contact sont formés par les moyens de transport (T) et en ce que l'alimentation de courant vers les moyens de transport se fait au moyen d'un contact par frottement ou d'un contact par galet.

13. Dispositif selon les revendications 8 et 12, caractérisé en ce qu'au moins un bain de nettoyage (RB) est situé dans la région où s'effectue le retour du dispositif de commande sans fin en vue du nettoyage chimique ou électrochimique des moyens de transport.

14. Dispositif selon l'une des revendications précédentes, caractérisé en ce que la remise en circulation du liquide de bain s'effectue, au moins en partie, par le biais de tuyaux de pulvérisation (SR) situés dans la cellule de traitement associée (BZ).

15. Dispositif selon la revendication 14, caractérisé par des tuyaux de pulvérisation orientés verticalement.

16. Dispositif selon la revendication 14 ou 15, caractérisé en ce que les tuyaux de pulvérisation sont situés sur les deux côtés des chemins de transport des circuits imprimés.

17. Dispositif selon l'une des revendications précédentes, caractérisé par un moyen pour introduire de l'air comprimé (DL) dans les bains de traitement.

18. Dispositif selon l'une des revendications précédentes, caractérisé en ce que les dispositifs d'étanchéité (D) sont formés par des cylindres agencés librement par paires orientées verticalement qui sont pressés, sous l'effet de la pression d'un bain de traitement (BB1 à BB3), l'un contre l'autre ou contre les circuits imprimés (LP) respectifs en train de traverser.

19. Dispositif selon la revendication 18, caractérisé en ce que les dispositifs d'étanchéité (D) sont situés dans des sas (SK) installés sur les côtés frontaux des cellules de traitement.
